# EUROPEAN PATENT APPLICATION

(11) **EP 2 501 040 A1**
(43) Date of publication of application: **19.09.2012**
(21) Application number: 11158865.3
(22) Date of filing: 18.03.2011
(51) Int. Cl.: H03K 3/356, G01R 31/3185, G11C 29/32

(54) **Scannable configuration memory**

(71) Applicant: Panasonic Corporation, Kadoma-shi Osaka 571-0051 (JP)
(72) Inventor: Bonwick, Paul, Bristol, BS1 6EA (GB)
(74) Representative: Haley, Stephen

(57) **Abstract**

A configurable memory element for a programmable logic device (PLD) is described comprising an odd latch operable to store an odd data bit and an even latch operable to store an even data bit wherein said odd and even latch are arranged so that an output of the odd latch is chained to an input to the even latch. Control means are provided for configuring the memory element to operate in a first mode in which data can be read from or written to the odd latch and a second mode in which data can be read from or written to the even latch.

## Description

The present invention relates to memory devices for programmable logic arrays and in particular, but not exclusively, to scanable configuration memory elements.

Programmable logic array devices (PLAs) typically comprise a number of configurable logic units the functionality of which is typically configured by data stored loaded in associated configuration memories. Configuration memory for PLA type devices is usually stored in memory elements such as SRAMs. The nature of SRAM based memories is such that the circuit can be tested by conventional field programmable gate array test methodologies. For example, such a methodology may comprise loading a test configuration to the configuration memories and then applying test vectors to the circuit and monitoring the outputs (e.g. via the bit lines of the SRAM cells). The inherent programmability of the PLA device facilitates access to most internal nodes of the circuit to permit useful monitoring during test. This methodology is usually adequate because it allows good test coverage with a small number of test patterns and therefore only requires a short test time. Also, there is only a small overhead in test circuitry die area. However, creating suitable test configurations and vectors can be a very labour intensive task and hence can have a significant cost in terms of man-hours of the test engineers. In addition, there is also the possibility of human error which could leave some of circuitry inadequately tested.

Where a PLA device is fabricated as part of an application specific integrated circuit (ASIC) device, it is desirable to use an ASIC test methodology on the PLA portion of the device. In order to use an ASIC test methodology it is required that all memory should form part of a 'scan chain'. An automatic test pattern generator (ATPG) tool is used to generate patterns of test data automatically and load the test pattern into the scan chain. Using ATPG methodologies is advantageous in that it removes the need to manually create many test configurations and vectors needed by the standard FPGA test methodology.

However, if the configuration memory were to be implemented with full scan registers - e.g. D-type flip flops (DFFs) - would be costly in terms of die area. Conventional DFFs contain approximately twice as many transistors as a conventional SRAM cell. Therefore the size of the configuration memory would approximately double if SRAMs were substituted with DFFs for use as a scan chain. Further, in a PLA the configuration memory consumes a significant portion of the die area and therefore the die area would have to be significantly increased which is expensive.

The majority of PLA devices are not fabricated as part of an ASIC device and accordingly these devices can be tested using the standard FPGA type test methodologies.

There is therefore a need to facilitate scan testing of PLA configuration memory using an ASIC type methodology without the area cost associated with using full scan DFFs.

In a first aspect there is provided a configurable memory element for a programmable logic device (PLD) comprising
an odd latch operable to store an odd data bit and an even latch operable to store an even data bit wherein said odd and even latch are arranged so that an output of the odd latch is chained to an input to the even latch; and
means operable to configure the memory element for operation in both of a first mode in which data can be read from or written to the odd latch and a second mode in which data can be read from or written to the even latch.

The memory cell according to this aspect is advantageous because it permits a circuit arrangement having fewer elements and therefore smaller die area than a register based cell while still permitting an easy way to test the integrity of the cell.

In a further aspect there is provided a configuration memory for a programmable logic device comprising a plurality of memory elements according to the first aspect whereby said memory elements are arranged in a chain.

By providing a chain of memory cells according to the first aspect a configuration memory can be formed which is small in area and testable using conventional ATPG tools.

Alternatively, the control means is operable in the second mode to bypass the even latch and preferably the control means comprises at least one bypass latch arranged to receive signals from the output of the odd latch in the first mode.

Although requiring more circuit elements this alternative permits simpler operation whereby data can be written to and read from the odd latch or the even latch respectively in a single scan. The single scan includes periods of operation in both the first and second mode to read from (or write to) the odd and even latches respectively.

Preferably, the control means comprises scan chain access means operable in the second mode to connect the even latch to scan lines of a scan chain of a configurable memory such that data can be read or written to or from the even latch directly via the scan lines. This permits access to the even latch in a second mode whereby access is provided by word lines that address the even latch directly. This means data can be written to the even latch without scanning data through the odd latch.

Embodiments of the present invention will now be described with reference to the accompanying drawings in which:
Figure 1 shows a simplified schematic of a programmable logic device (PLD) architecture;
Figure 2 shows a simplified schematic of a tile in the programmable logic device of Figure 1;
Figure 3 shows a circuit diagram of a conventional SRAM cell;
Figure 4 shows how the SRAM cell of figure 3 can be used in a configuration memory scan chain of a programmable logic device;
Figure 5 shows a memory pair cell in a first embodiment of the present invention;
Figure 6 shows a configuration memory scan chain including the memory pair cell of figure 5;
Figure 7 shows a timing diagram of the scan chain of figure 6 in a process for writing odd data;
Figure 8 shows a timing diagram of the scan chain of figure 6 in a process for writing even data;
Figure 9 shows a timing diagram of the scan chain of figure 6 in a process for reading odd data;
Figure 10 shows a timing diagram of the scan chain of figure 6 in a process for reading even data;
Figure 11 is a block diagram showing a further embodiment in which the memory pair cell of figure 5 has been simplified such that only non-inverting outputs are required;
Figure 12 shows a memory pair cell in a second embodiment of the present invention;
Figure 13 shows a configuration memory comprising the memory pair cell of figure 12;
Figure 14 is a timing diagram showing a write operation to the configuration memory of Figure 13;
Figure 15 is a timing diagram showing a read operation to the configuration memory of Figure 13.

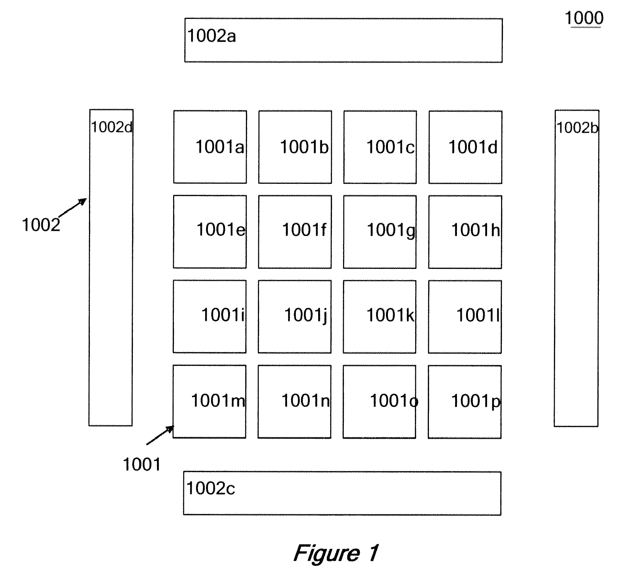

Figure 1 illustrates simplified programmable logic device (PLD) architecture 1000 of the present invention in plain view. The PLD 1000 includes an array of tiles 1001a - 1001p, programmable input/output (I/O) blocks 1002a - 1002d. Some of the tiles 1001a - 1001p and I/O blocks 1002a - 1002d are connected by a number of connecting lines (not shown in figure 1). Clock signals are distributed by, for example, clock trees such as a balanced tree (e.g. the H clock tree).

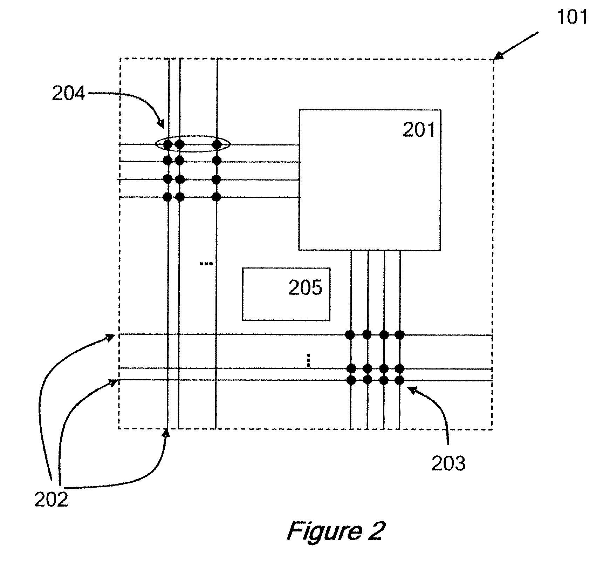

Figure 2 shows simplified illustration of a tile 1001, which is one of the tiles 1001a - 1001p. The tiles 1001a - 1001p have similar structure. In other words, the tile 1001 is a repeating unit of the PLD 1000. The tile 1001 includes a logic block 201, a number of interconnecting lines 202 and configuration memory block 205. The logic block 201 includes logic circuits and at least one D-type flip-flop (D-FF) for holding data. The D-FF can be a part of a scan chain and the D-FF can be tested by conventional scan test. The interconnecting lines are interconnected by programmable interconnect points 203 (PIPs, shown as small dots in figure 2). PIPs are often coupled into groups (e.g. group 204) that implement multiplexer circuits selecting one of several interconnecting lines to provide a signal to a destination interconnecting line or the logic block 201. The PIPs 203 are controlled by control signals based on the configuration data stored in the configuration memory block 205. The configuration memory block 205 comprises a plurality of latch circuits.

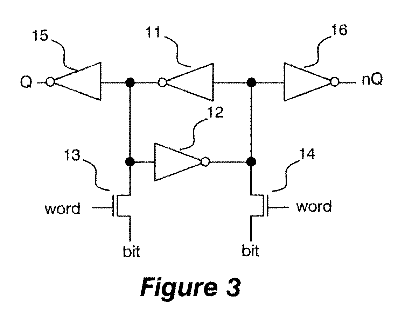

Figure 3 shows a conventional SRAM configuration memory cell typically used for configuration memory such as that provided to the PLA device of Figures 1 and. The SRAM comprises first and second cross coupled inverters 11 and 12 and two access transistors 13 and 14. The inverters 11 and 12 are connected in a positive feedback loop thereby forming a flip-flop or latch. The two access transistors 13 and 14 have gates connected to a word line and are driven by a bit line 'bit' and its inverse 'nbit' respectively. The access transistors 13 and 14 are turned on when the word line is selected (i.e. its voltage crosses the turn-on threshold value of the transistor) at which point they connect the latch formed by the cross-coupled inverters 11 and 12 to the bit line and its inverse respectively. The access transistors permit bi-directional current flow between the latch and the bit lines 'bit' and 'nbit' for the purpose of 'read' and 'write' operations.

In addition, the SRAM cell is provided with output Q at the output of the first inverter 11 and its inverse nQ at the output of the second of the coupled inverters 12. Buffer inverters 15 and 16 are provided to buffer the output of the latch from the surrounding circuitry in the PLA whereby uncontrolled capacitance to other tracks could lead to noise risking the SRAM inadvertently flipping state. However, in some cases they can be omitted entirely or if only one of the outputs Q or nQ is required then the inverter driving the un-required output can be removed.

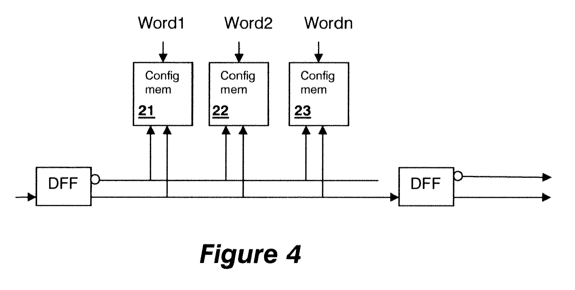

Figure 4 shows how the conventional SRAM cell of figure 3 is replicated and arranged to form a configuration memory loaded via a scan chain on a PLA device. The configuration memory comprises a plurality of configuration memory cells 21, 22 and 23 each comprising an SRAM as shown in figure 3. The scan chain comprises a DFF having an output and an inverse output which drives the non-inverting and inverting bit lines respectively of each of the SRAM cells 21, 22 and 23. This scan chain could be a dedicated scan chain used only for configuration or it could utilise registers of the circuit design. In either case configuration data would be loaded into the scan chain via the DFF. Once the DFF scan chain is loaded with data the word line of one or more of the cells 21, 22 and 23 can be toggled at an appropriate time so that the scan contents are latched in the corresponding SRAM cell.

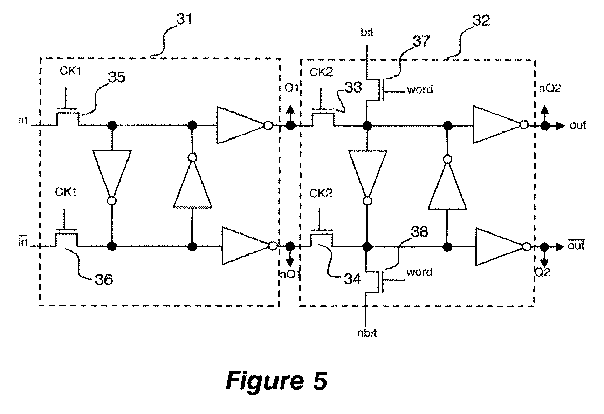

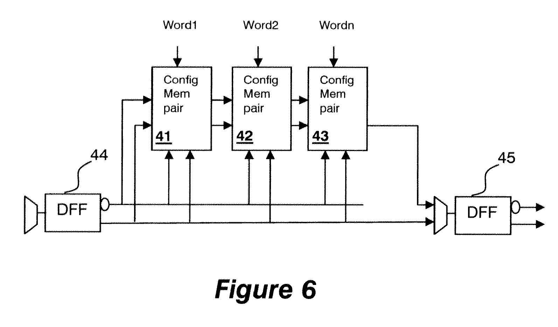

A first embodiment of the present invention is shown in figures 5 and 6 which show a configuration memory element and corresponding scan chain respectively.

The conventional SRAM cell can be replaced with the memory pair cell shown in figure 5. The cell effectively comprises odd and even latches 31 and 32. The odd latch 31 has its outputs Q1 and nQ1 chained to even latch 32 via clocked access transistors 33 and 34. Access to the odd latch element is provided via clocked input access transistors 35 and 36. Bit-line access transistors 37 and 38 provide another route by which the even latch can be accessed via bit lines bit and nbit. The gate of transistors 37 and 38 is connected to an associated word-line which allows access to the even latch in a similar manner to an SRAM cell. Each latch has the capacity to hold a bit of data at their respective outputs Q1 and Q2.

Multiple memory pair cells 41, 42 and 43 are chained together as shown in Figure 6 to form a configuration memory. The outputs of an input DFF 44 are connected to both the bit lines of the memory pair cells 41, 42 and 43 and the inputs of the access transistors 35 and 36 of the first flip flop 31 of the memory pair cell 41 located at the beginning of the memory chain.

In this configuration it is possible to scan data through the cells and monitor its output via a second DFF connected to the end of the chain. This can be achieved by configuring CK1 to be equal to the DFF-CK and CK2 to be the inverse of CK1 with all word lines set to zero. Test configuration data generated by, for example, an ATPG tool would be scanned through the cells beginning at the DFF and passing through each of the latches. For example when CK1 is high then CK2 is low and data is loaded from the DFF into the first latch 31. When the DFF clock goes low then CK1 goes low and CK2 goes high meaning the data latched at Q1 and nQ1 is loaded into the even latch 33. At this stage both the odd and even latches have the same data i.e. Q1=Q2. At the next clock cycle the CK1=DFF-CK=high and CK2=low and the odd latch 31 of the first memory pair 41 is loaded with the next value while Q2 and nQ2 are held at the same value. Also, the access transistors 35 and 36 of the next memory pair 42 are high so the value at Q2 and nQ2 is loaded into the odd latch of memory pair 42. At this point Q2=Q3 where Q3 represents the output of the odd latch of the next memory cell pair 43 in the scan chain.

As can be seen the odd and even latches are loaded at alternate clock cycles from the preceding memory and in this way data can be scanned through the chain. In this way it is easy for a tester to test the integrity of the memory cells for defects by passing for example a 'walking 1', 'walking 0', 'checkerboard' etc pattern through the memory. The last latch in the chain has its output Q connected to a multiplexer which can be configured with a zero to select the output from the last latch and put this in the next scan chain DFF. This DFF provides a convenient test point which can be monitored to check that the expected values have been scanned through the memory pair chain.

However, as the data is stored in latches rather than registers or DFFs, alternate memory will take the same value i.e. Q1=Q2 or Q2=Q3 as described above. This is acceptable, however, for test purposes where the data scanned through the chain comprises random test configurations generated by an ATPG tool as for testing purposes all that matters is that the data passes uncorrupted to the end of the chain.

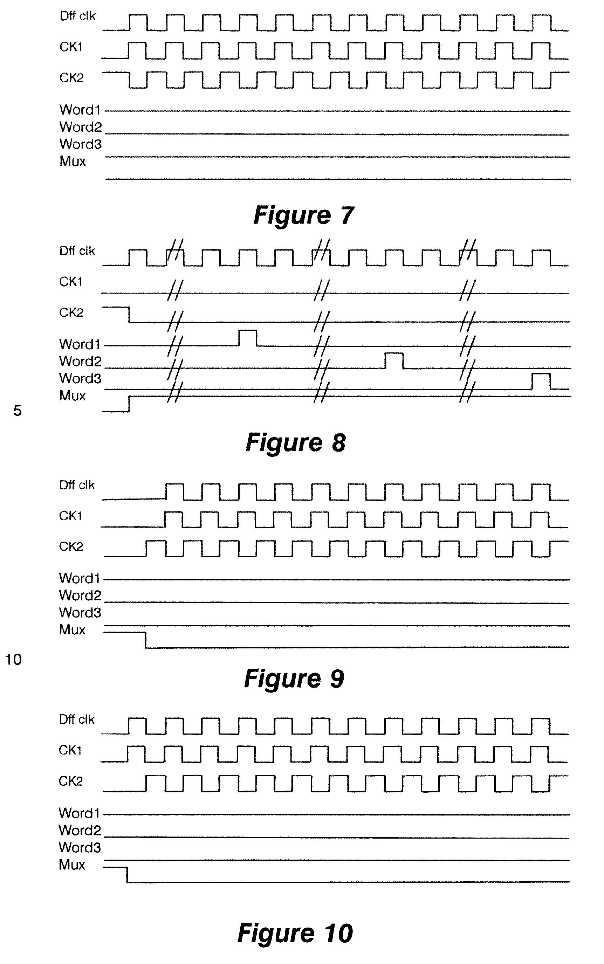

The memory can also operate in a non-test mode whereby data can be written to the odd and even latches in two distinct modes of operation. Firstly, to write data to the odd latches, the odd data to be loaded is scanned through the configuration cells then the clock is stopped with CK2 set high and CK1 set low. This loads all the odd data. A timing diagram showing the respective states of the DFF clock, CK1, CK2, Word line 1, Word line 2, Word line 3 and MUX is shown in figure 7. Once the odd data has been loaded then the even data can be loaded by setting CK1 equal to CK2=low thereby bypassing the configuration memory in the scan chain. The even latches of the memory are loaded by scanning in the data and toggling the appropriate word line in the same manner as for a conventional SRAM configuration memory. A timing diagram is shown in figure 8 illustrating the writing process to the even latches.

The contents of the configuration memory can be read out for testing or other purposes but only the odd or even latches can be read per scan. An example of process to test the configuration memory would be to i) load user configuration data (as described above), ii) perform some user cycles of the programmable logic configured according to the configuration data and iii) scan out the contents of the configuration memory to check that they have not been corrupted. As only the odd or even latches can be read per scan then this test would be done in two stages one for the even latches and one for odd latches.

To scan out the odd data, CK2 is set high first and CK1 set to the DFF clock and CK2 the inverse of CK1 (as per the scanning process already described above). A corresponding timing diagram is shown in figure 9. To scan out the even data CK1 is set high first and then CK1 and CK2 are clocked as before with CK1 the inverse of CK2. A timing diagram showing an example of the sequence of signals required to read out the even data is shown in figure 10.

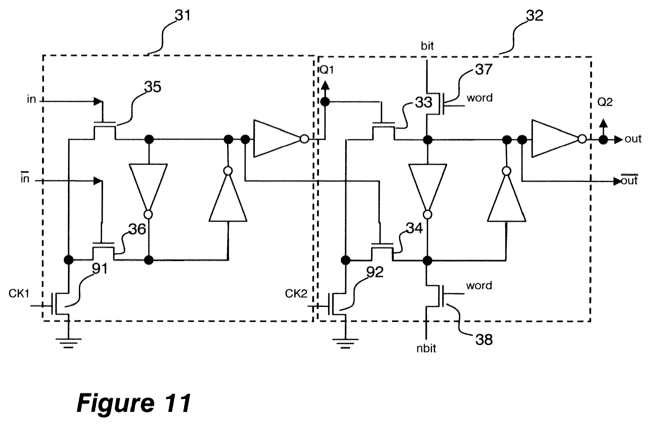

The circuit shown in figure 5 can be further simplified if the inverted outputs nQ1 and nQ2 are not required by the circuit as shown in figure 11. In this embodiment the gates of the access transistor pairs 33, 34 and 35, 36 are connected to output Q1 (or Q2) and its inverse Q1n by connection to the node preceding the buffer inverter. The access transistors 33, 34 and 35, 36 are grounded via a respective transistor 91, 92 gated by clock signal CK1 (or CK2). Thus, when CK1=high, both access transistors to the odd latch are grounded and the state of the latch is flipped based on the values at the gates of the access transistors. When CK1=low, then the clocked transistor 91 presents a high impedance and the latch 31 remains in a steady state regardless of signal transitions at the gates of transistors 35 and 36. Latch 32 operates in a similar manner via transistor 92 in response to CK2=low.

### Second Embodiment

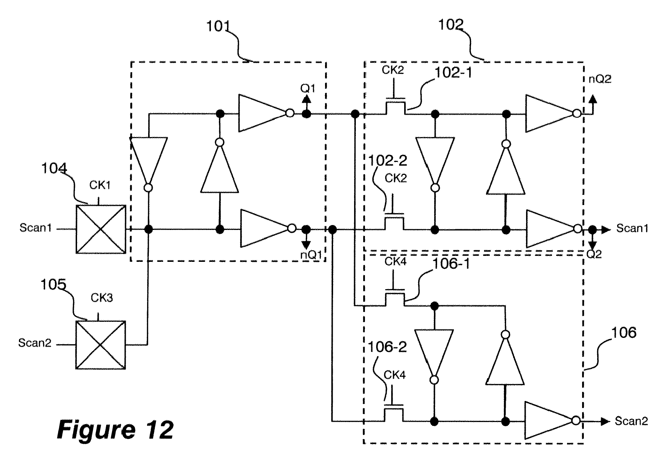

Figure 12 shows a second embodiment of the invention which does not utilise word lines to write data to the even latches. In this embodiment data can be written or read to both the odd and even latches in one scan of the scan chain. As shown in figure 12 the memory cell pair 100 of this embodiment comprises odd and even latches 101 and 102 the output of the odd latch being chained to the input of the even latch as before. The even latch 102 has corresponding access transistor pair 102-1 and 102-2 which control access to the inputs of the latch 102 having outputs Q2 and nQ2. However the odd latch 101 has a single input 103 at the node between its two cross-coupled inverters. Two transmission gates (e.g. parallel combinations of an nMOS and a pMOS transistor with the input at the gate of one transistor being complementary to the input at the gate of the other) 104 and 105 are connected to the input node 103 to control which the input to the odd latch 101. The gate of the transmission gates 104 and 105 being clocked by clock signals CK1 and CK3 respectively while scan data is provided to either the first or second transmission gates 104 or 105 depending on whether the cell is configured to write/read odd or even data.

In addition, there is also provided a bypass latch 106 whereby the outputs of the odd latch 101 are also chained to the inputs of the bypass latch 106 via access transistors 106-1 and 106-2. Access transistors 106-1 and 106-2 are gated by a fourth clock signal CK4. As will be explained further below, the bypass latch effectively allows the cell to bypass the even latch 102 and thereby write/read data to/from the odd latch 101 only. When the bypass latch 106 is 'off' i.e. when the clock signal CK4 associated with access transistors 106-1 and 106-1 is low.

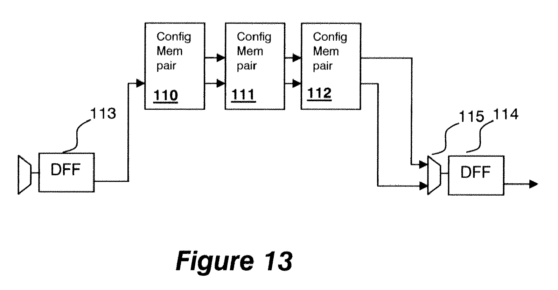

Figure 13 shows a configuration memory comprising three memory pair cells 110, 111 and 112 corresponding to those shown in figure 12 arranged in a scan chain. As can be seen there is a first DFF 113 at the beginning of the scan chain and a second DFF 114 at the end of the scan chain with a multiplexer 115 connected to the scan 1 and scan 2 outputs of the last memory cell 112 in the chain. The scan 1 and scan 2 outputs can be selected based on whether the data from the odd or even latches is being scanned.

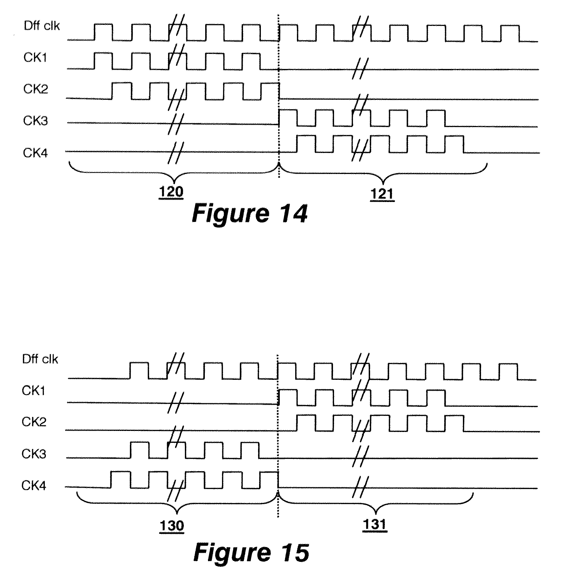

Operation of the scan chain of figure 13 for writing data to the memory cells 110, 111 and 112 will now be described with reference to timing diagrams shown in figures 14 and 15.

Figure 14 shows the writing process. In a first stage 120, CK3 is configured to be equal to CK4 which is low. CK1 is set to the DFF clock and CK2 equal to its inverse. Data is scanned until enough clock cycles have passed that data is loaded into the even latches (Q2). In a second stage 121, CK1=CK2=low and CK3 is set as the DFF clock while CK4 is set to be the inverse of CK3. Data is scanned again for the requisite number of clock cycles to load the odd latches (Q1) with data. Once the writing process is complete then CK1, CK2, CK3 and CK4 are all set to low.

Figure 15 shows the reading process. In a first stage 130, CK1 is set to low and CK2 is set equal to CK1. CK3 is set to the DFF clock and CK4 is set to the inverse of the DFF clock. Data is scanned through the chain for the requisite number of clock cycles to read the data from the odd latches. In a second stage 131, CK3 is set to low and CK4 is set to be equal to CK3. CK1 is set to the DFF clock and CK2 to the inverse of the DFF clock. Data is scanned again through the chain of cells to push out the even data where it can be read at the output DFF.

This embodiment is particularly advantageous as both the odd and even latches can be written to/read from in one go from the scan chain and there is no need for word lines thereby simplifying the configuration memory connections.

### Alternative embodiments

In the above embodiments the mode of operation of the memory cells is determined by the configuration of the clock signals and/or signals provided to the word lines or other transistor gates. This configuration would typically be performed by a control circuit outside the configuration memory according to the operation being performed. Inputs would be provided to the control circuit from external tools such as an ATPG tool in order to have the control circuitry configure the signals provided to the gates of the memory cells in accordance with the operation being performed. Data is loaded via the input DFF at the beginning of the scan chain from external signals and read out from the output DFF.

In the above embodiments the scan chains use DFFs to provide input and output to the chain, however as will be appreciated other clocked registers or storage elements could be used instead. Similarly, although the above embodiments are shown in the circuit diagrams as using MOSFETs it will be appreciated that other equivalent electronic elements could be used having the same functionality in accordance with common electronic circuit design procedures known to those skilled in the art.

## Claims

1. A configurable memory element for a programmable logic device (PLD) comprising
an odd latch operable to store an odd data bit and an even latch operable to store an even data bit wherein said odd and even latch are arranged so that an output of the odd latch is chained to an input to the even latch; and
control means for configuring the memory element to operate in a first mode in which data can be read from or written to the odd latch and a second mode in which data can be read from or written to the even latch.

2. A configurable memory element according to any preceding claim wherein said control means comprises access control means provided to the odd latch and gated by a first clock signal and access control means provided to the even latch and gated by a second clock signal and wherein, for example, the access control means comprises a transistor, a pair of transistors having differential inputs or a pass gate

3. A configurable memory element according to any preceding claim wherein in the first mode data is written to the odd latch by receiving data from a preceding storage element in a scan chain.

4. A configurable memory element according to any preceding claim wherein in the first mode data is read from the odd latch by scanning the data held in the odd latch through the even latch.

5. A configurable memory element according to claims 2 to 4 wherein in the first mode the access control means of the even latch is configured to receive a second clock signal that is the inverse of a first clock signal provided to the access control means of the odd latch.

6. A configurable memory element according to any preceding claim wherein said control means comprises scan chain access means operable in the second mode to connect the even latch to scan lines of a scan chain of a configurable memory such that data can be read or written to or from the even latch directly via the scan lines.

7. A configurable memory element according to claim 6 wherein the scan chain access means comprises:
at least one access transistor having an output connected to the input of the even latch;
a bit line connection connected to the signal input of the access transistor;
a word line connection connected to the gate of the access transistor; and
wherein in the second mode access to the even latch by the scan lines is controllable by the scan chain access transistor.

8. A configurable memory element according to any of claims 1 to 5 wherein the memory element control means is operable in the second mode to bypass the even latch.

9. A configurable memory element according to claim 8 wherein said control means comprises at least one bypass latch arranged to receive signals from the output of the odd latch in the first mode.

10. A configurable memory element according to claim 9 wherein the control means further comprises a second transmission gate connected to the input of the odd latch and controlled by a third clock signal.

11. A configurable memory element according to claim 10 wherein the bypass latch comprises access control means gated by a fourth clock signal, preferably comprising a transistor pair having differential inputs, wherein in the second mode of operation the fourth clock signal is arranged to be the inverse of the third clock signal.

12. A configurable memory element according to claim 12 wherein the first and second clock signals are configured low in the second mode of operation and the third and fourth clock signals are configured low in the first mode of operation.

13. A configuration memory for a programmable logic device comprising a plurality of memory elements according to any of claims 1 to 12 arranged in a chain.

14. A configuration memory according to claim 13 wherein the memory elements are further arranged to be connected to a scan chain comprising an input register having at least one output connected to an input of the chain of memory elements wherein the input register is preferably a D-type flip-flop having a shared clock with at least one clock signal provided to the memory elements.

15. A configuration memory according to claim 15 further comprising selection means having an output, a first input connected to the output of the input register and a second input connected to an output of the last memory element in the chain of memory elements, wherein the output of the scan chain or the register can be selected as an output from the selection means and the selection means preferably comprises a multiplexer.
